# EUROPEAN PATENT SPECIFICATION

(11) **EP 2 932 568 B1**
(45) Date of publication and mention of the grant of the patent: **27.10.2021**
(21) Application number: 13795301.4
(22) Date of filing: 05.11.2013
(51) Int. Cl.: H01S 3/02, H01S 3/06, H01S 3/0941, H01S 5/04, H01S 5/14, H01S 5/42, H01S 3/07, H01S 3/08, H01S 5/00, H01S 5/02325

(54) **OPTICALLY PUMPED SOLID STATE LASER DEVICE WITH SELF ALIGNING PUMP OPTICS AND ENHANCED GAIN**
OPTISCH GEPUMPTE FESTKÖRPERLASERVORRICHTUNG MIT SELBSTAUSRICHTENDER PUMPENOPTIK UND ERHÖHTER VERSTÄRKUNG
DISPOSITIF LASER À L'ÉTAT SOLIDE OPTIQUEMENT POMPÉ AYANT DES OPTIQUES DE POMPAGE À AUTO-ALIGNEMENT ET À GAIN AMÉLIORÉ

(30) Priority: 11.12.2012 US 201261735682 P
(43) Date of publication of application: 21.10.2015
(73) Proprietor: Koninklijke Philips N.V., 5656 AG Eindhoven (NL); Philips GmbH, 20099 Hamburg (DE)
(72) Inventor: GRONENBORN, Stephan, NL-5656 AE Eindhoven (NL)
(74) Representative: Philips Intellectual Property & Standards
(86) International application number: PCT/IB2013/059898
(87) International publication number: WO 2014/091326

(56) References cited:
- DE-A1- 19 541 020
- DE-A1- 19 728 845
- JP-A- 2003 060 299
- JP-A- 2006 165 292
- SEURIN JEAN-FRANCOIS ET AL: "High-power vertical-cavity surface-emitting lasers for solid-state laser pumping", VERTICAL-CAVITY SURFACE-EMITTING LASERS XVI, SPIE, 1000 20TH ST. BELLINGHAM WA 98225-6705 USA, vol. 8276, no. 1, 9 February 2012 (2012-02-09), pages 1-10, XP060001283, DOI: 10.1117/12.906864 [retrieved on 1901-01-01]
- None

## Description

### FIELD OF THE INVENTION

The present invention relates to an optically pumped solid state laser device comprising one or several solid state laser media in a laser resonator and one or several pump laser diodes to optically pump the solid state laser media, said laser resonator being formed of one or several first resonator mirrors arranged at a first side of said solid state laser media and one or several second resonator mirrors arranged at an opposing second side of said solid state laser media, said first and second resonator mirrors being arranged to guide laser radiation of said laser resonator on at least two different straight paths through each of said laser media. An example for optically pumped solid state laser devices of this kind are optically pumped vertical extended cavity surface emitting lasers (VECSELs) or semiconductor disc lasers (SDL) which offer a compact and low-cost solution for medium laser powers with high brightness, narrow bandwidth and short laser pulses. Such laser devices can be used for a huge number of applications requiring higher brightness and/or shorter pulses than can be delivered by laser diodes.

### BACKGROUND OF THE INVENTION AND PRIOR ART

Standard disc lasers need precise alignment of the pump lasers and the pump laser optics with respect to the optical mode of the laser resonator. This alignment is difficult during the fabrication of the laser device. Furthermore, such lasers are often limited in the power of the low brightness pump radiation that can be focused in a given active area of the laser medium which results in a low gain of the laser device. Also the maximum dissipated power density in the laser medium is often limited by the cooling method, in particular a heat sink onto which the laser medium is mounted.

US 5,553,088 A discloses a solid state laser device comprising one or several disc shaped solid state laser media in a laser resonator. The laser resonator in at least one of the embodiments is formed of a first resonator mirror formed of a first end face of the solid state laser medium and several second resonator mirrors arranged at an opposing second side of the solid state laser medium. The resonator mirrors are arranged to guide the laser radiation of the laser resonator on two different paths through the laser medium. The laser medium is pumped by several laser diodes from the side which are arranged at the same carrier element as the solid state laser medium. The proposed device allows an enhanced gain of the laser medium due to the propagation of the laser radiation on different paths through the laser medium. This also allows a better distribution of the generated heat and results in an improved cooling. The document does not propose any solution for an easier alignment of the pump optics in case of optical pumping through one of the end faces of the laser medium through which the laser radiation passes.

DE 197 28 845 A1 discloses a laser amplifier which includes an active solid state material. One or more pumping beams are fed via mirrors or other optical devices, such that each individual pumping beam is focussed onto different parts of the material multiple times. The laser beam is fed so that all these parts are irradiated and thus amplified. The solid-state material is composed of several blocks of the same base material, but in part doped and in part undoped such that the pumping beam is absorbed only in the doped blocks. The blocks are connected together by diffusion bonding after polishing of the surfaces, so that the mechanical cohesion is comparable to that of the solid-state material. JP 2006 165292 A and JP 2003 060299 A disclose multifunctional integral optical elements comprising different surfaces acting for different purposes of beam transmission and reflection.

### SUMMARY OF THE INVENTION

It is an object of the present invention to provide an optically end-pumped solid state laser device with one or several solid state laser media which enables an easy alignment of the pump optics and can be realized in a compact manner.

The object is achieved with the optically end-pumped solid state laser device according to claim 1. Advantageous embodiments of the device are subject matter of the dependent claims or can be deduced from the subsequent portions of the description and preferred embodiments.

The proposed optically end-pumped solid state laser device comprises one or several preferably disc or plate shaped solid state laser media in a laser resonator. The laser resonator is formed of one or several first resonator mirrors arranged at a first side of the solid state laser media and one or several second resonator mirrors arranged at a second side of the solid state laser media opposing said first side. The first and second resonator mirrors are arranged to guide the laser radiation of the laser device on at least two different straight paths through each of said laser media. The laser can be designed for example to be a VECSEL wherein each laser medium is formed of a quantum-well structure on a DBR (distributed Bragg reflector) which forms one of the first resonator mirrors or a disc laser. One or several laser pump laser diodes and pump radiation reflecting mirrors are arranged to optically pump the solid state laser media by reflection of the pump radiation of the pump laser diodes at said pump radiation reflecting mirrors. The pump radiation reflecting mirrors are situated on the second side together with the second resonator mirrors and are arranged and designed to directly reflect the pump radiation to the end faces of the solid state laser media on the second side. The pump reflecting mirrors and the second resonator mirrors are integrally formed in a single mirror element on the second side of the solid state laser media. The first resonator mirror or resonator mirrors may be formed of the end faces of the laser media on the first side. To this end, the end faces of crystalline laser media may be appropriately coated to achieve a high reflection of the laser radiation at these end faces. The first resonator mirrors are formed of the DBR(s) on which the laser medium (active medium) is arranged.

The solid state laser device of the present invention uses an appropriately designed mirror element which directs the pump light into the solid state laser media and at the same time forms the second resonator mirrors of the laser resonator. The pump radiation mirrors formed in this mirror element are designed to pump the areas of the laser media which cover the modes of the laser radiation on the different paths through these laser media. Therefore, the pump beams and the laser mode always overlap without complicated alignment since the parts of the mirror element forming the pump optics are always in a fixed spatial relationship to the parts of the mirror element forming the second resonator mirrors. With such a self-centering mirror element the alignment of the pump optics is significantly simplified. The proposed design allows the arrangement of the pump laser diodes close to the laser media resulting in a very compact design of the solid state laser device. Due to the different paths of the laser radiation through the solid state laser media, a higher amount of pump energy can be deposited resulting in an enhanced gain of the laser device compared with a similar laser in which the laser radiation always propagates on the same path through the laser medium. The different paths also allow a better heat distribution and thus a better cooling of the solid state laser device. The cooling is preferably achieved through cooling body with a plane surface onto which the laser media are mounted adjacent to each other. The pump laser diodes may also be mounted on this cooling body adjacent to and/or between the solid state laser media. The pump laser diodes then emit the pump radiation substantially perpendicular to the end faces of the solid state laser media towards the mirror element. The cooling body may be a heat sink of a bulk material, in particular a metal, and may also have cooling fins for air cooling. It is also possible to realize this cooling body as a chamber for a cooling liquid, for example water, which is pumped through the cooling body during operation of the laser device.

The pump laser diodes maybe single diodes or arrays of laser diodes, for example vertical cavity surface emitting laser (VCSEL) arrays or microchip-VECSEL arrays. The body of the mirror element is preferably formed of an optically transparent material, for example a coated glass or coated plastics. The coating for the mirrors may be formed of a metallic coating or of a dielectric coating as known in the art.

The proposed laser device may comprise at least two solid state laser media mounted adjacent to each other on an appropriate carrier element, in particular a cooling body. Each of these laser media are preferably surrounded by several pump laser diodes on the carrier element. The mirror element may then comprise one pump radiation reflecting mirror for each of said laser media, said pump radiation reflecting mirror being preferably centered with respect to the corresponding laser media. On the mirror element, these pump radiation reflecting mirrors are arranged between the second resonator mirrors which reflect the laser radiation coming from one of the laser media to the adjacent laser medium. This results in a zig-zag-path of the laser radiation between the first and second resonator mirrors through the laser device and in the different straight paths through the laser media. The pump laser diodes and pump radiation reflecting mirrors are arranged and designed such that each of these paths is sufficiently optically pumped to achieve the required gain. One of the two outer resonator mirrors of the mirror element is designed to form the outcoupling mirror of the laser resonator. This means that this mirror allows the passage of a small portion of the laser radiation through the mirror to the outside of the laser resonator.

In a further embodiment, the proposed solid state laser device comprises one single solid state laser medium arranged on an appropriate carrier element. Also in this embodiment, the solid state laser medium is preferably surrounded by several pump laser diodes on said carrier element. In this embodiment the mirror element may comprise a central region which forms the second resonator mirrors and an outer region which is designed to reflect the pump radiation to the solid state laser medium and forms the pump radiation reflecting mirror(s). Depending on the number of second resonator mirrors, the laser radiation may be guided on substantially more than two different paths through the laser medium, resulting in a zig-zag-path of the laser radiation between the first and second resonator mirrors through the laser device like that in the previous embodiment. The outer region of the mirror element is then designed to generate an intensity distribution of the pump radiation at the facing end face of the solid state laser medium which covers the modes of all of the different paths of the laser radiation through this laser medium. Also in this embodiment one of the second resonator mirrors is designed to form the outcoupling mirror of the laser resonator.

These and other aspects of the invention will be apparent from and elucidated with reference to the embodiments described hereinafter.

### BRIEF DESCRIPTION OF THE DRAWINGS

The proposed solid state laser device is described in the following by way of examples in connection with the accompanying drawings in further detail. The figures show:
- Fig. 1: a cross sectional side view of a first example of the proposed laser device;
- Fig. 2: a top view on the solid state laser media of the laser device of figure 1;
- Fig. 3: a top view on the mirror element of the laser device of figure 1;
- Fig. 4: a cross sectional side view on a second example of the proposed solid state laser device;
- Fig. 5: a top view on the solid state laser medium of the laser device of figure 4;
- Fig. 6: a top view on the mirror element of the laser device of figure 4;
- Fig. 7: a cross sectional view along ring path A indicated in figure 6.

### DETAILED DESCRIPTION OF EMBODIMENTS

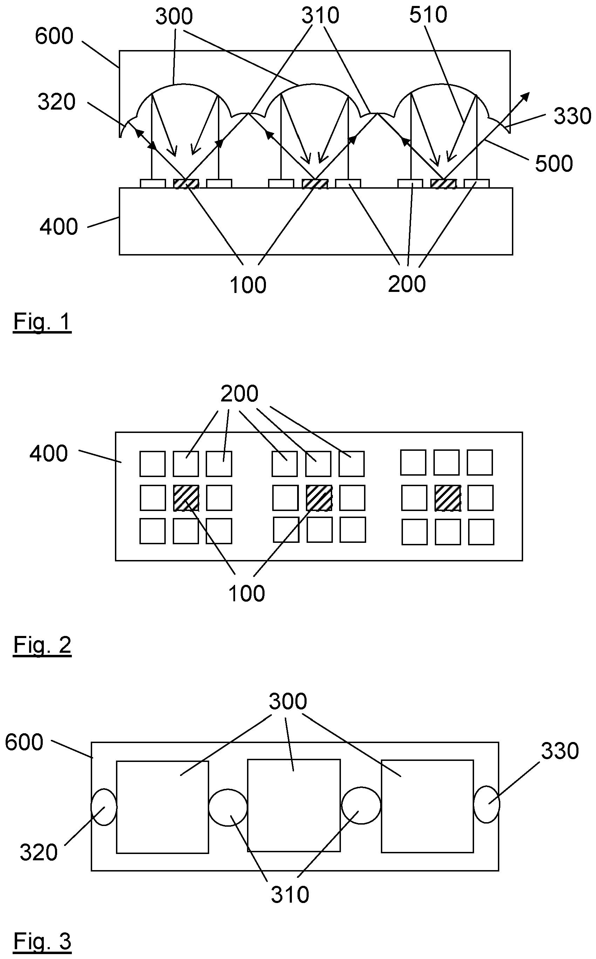

Figure 1 shows a cross sectional side view of a first example of the proposed solid state laser device. The laser device comprises three plate shaped solid state laser media 100 mounted side by side on a plane surface of a heat sink 400. Each of these laser media 100 may be formed of the active area of a VCSEL and is surrounded by several pump laser diodes 200 as can be recognized from the top view onto the laser media and heat sink shown in figure 2. The laser resonator in this example is formed of seven resonator mirrors arranged on both sides of the laser media. The first resonator mirrors are formed of the DBRs of the VCSELs which provide the laser media 100. The end mirror 320, the outcoupling mirror 330 and two folding mirrors 310 are arranged on the opposing second side of the laser media 100. With the shown arrangement of the resonator mirrors the laser radiation 500 propagates on a zig-zag-path through the laser device. Each of the laser media 100 is passed on two different paths. The arrangement also comprises three pump radiation reflecting mirrors 300 which are arranged and designed to direct the pump radiation 510 towards the end faces of the laser media 100. The second resonator mirrors 310, 320, 330 are integrally formed together with the pump radiation reflecting mirrors 300 in one single optical element 600. Since this optical element can be fabricated with high precision, the relative orientation and arrangement between the pump radiation reflecting mirrors 300, i.e. the pump optics, and the second resonator mirrors 310, 320, 330 can be ensured perfectly without any further alignment. Thus the alignment of the pump optics with respect to the laser resonator is achieved very easily when mounting the proposed laser device. The pump radiation reflecting mirrors are formed of three parabolic surfaces as indicated in figure 1. The radiation of the pump laser diodes 200 is thus reflected and focused on the active media (laser media 100) and overlaps with the optical mode of the resonator in these media.

Figure 3 shows a top view on the optical element 600 in which the adjacent arrangement of the pump radiation reflecting mirrors 300 and the second laser mirrors, end mirror 320, folding mirrors 310 and outcoupling mirror 330, can be recognized.

Of course, the three laser media 100 could also be replaced by a single, rectangular shaped active medium extending between the two outer laser media 100 of figure 1. The pump laser diodes 200 would then be located along the long edges of the rectangular laser medium. The mirror element 600 would provide the folding mirrors 310 directly adjacent to each other with the pump mirrors 300 on both sides. Of course, this is only one of several further possibility of an arrangement according to the present invention.

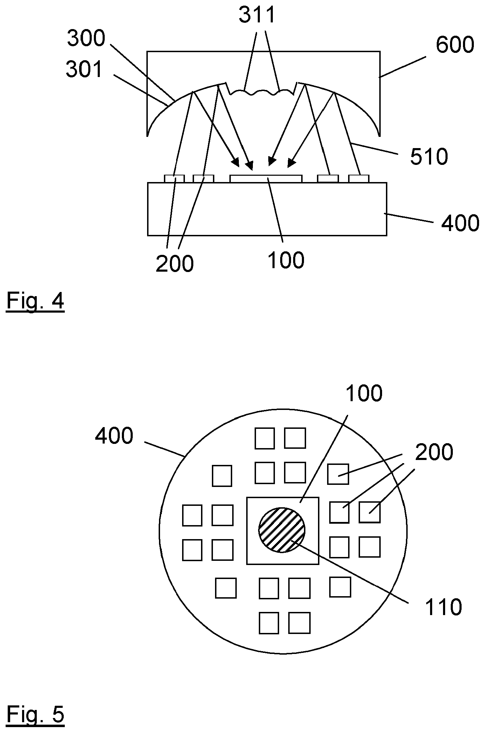

Figure 4 shows a side view of a second example of the proposed solid state laser device. In this example only one solid state laser medium 100 is arranged on a plane surface of a heat sink 400. This solid state laser medium is surrounded by several pump laser diodes on the same surface of the heat sink 400. An example for such an arrangement of the pump laser diodes 200 is shown in the top view on the solid state laser medium 100 in figure 5.

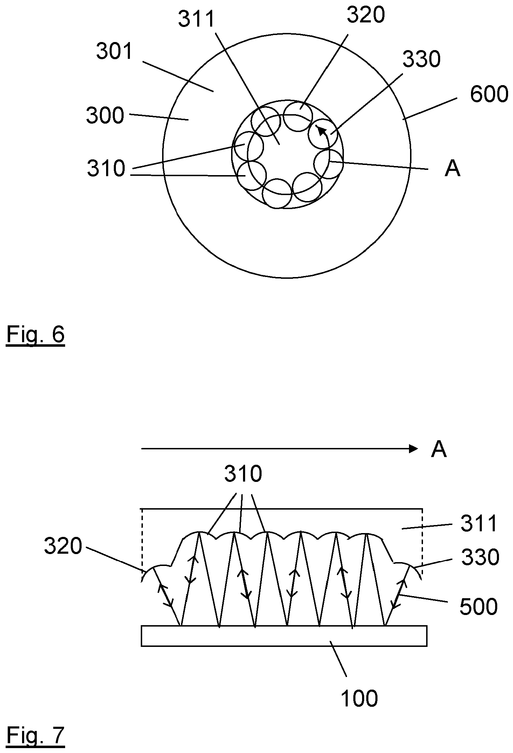

The mirror element 600 in this embodiment comprises an outer section 301 reflecting the pump radiation onto the end face of the solid state laser medium 100. The central portion 311 of the mirror element 600 forms the second resonator mirrors. In this case, the radiation of all pump laser diodes 200 is focused by the pump radiation reflecting mirror(s) in outer portion 301 of the mirror element 600 on a single spot 110 which is larger than the typical mode size of the resonator (see figure 5). For state of the art disc lasers, a pumped area much larger than the mode size would result in multimode operation with a reduced brightness. In this embodiment however a circular arrangement of several folding mirrors 310 reflects the laser mode at several different positions through the pumped area 110. This arrangement of the folding mirrors 310 is shown in the top view on the reflecting side of the mirror element 600 shown in figure 6.

Figure 7 shows the optical paths of the laser radiation in a cross sectional view along circular line A indicated in figure 6. In this cross sectional view also the end mirror 320 and the outcoupling mirror 330 of the laser resonator are indicated. Since figure 7 shows a cross section along a circular line, the resonator end mirror 320 and the outcoupling mirror 330 are arranged adjacent to each other on the mirror element 600. It is obvious for the skilled person that also the central part of the pumped area can be filled with the optical mode by an appropriate arrangement of the folding mirrors 310.

While the invention has been illustrated and described in detail in the drawings and forgoing description, such illustration and description are to be considered illustrative or exemplary and not restrictive; the invention is not limited to the disclosed embodiments. For example, although the figures show only three different laser media, another number of such media can be provided, for example two or more than three. The number of different paths through the laser media or through the whole device, in particular forming the zig-zag-path, and the corresponding folding mirrors 310 are not limited to the disclosed number. Furthermore, functional laser elements for the solid state laser like etalons, non-linear crystals, SESAMs (Semiconductor Saturable Absorber Mirrors), saturable absorbers, polarizers, Pockels-cells, AOMs (Acousto-Optical Modulators) can be integrated in the laser device. The reference signs in the claims should not be construed as limiting the scope.

### LIST OF REFERENCE SIGNS

- 100: laser medium
- 110: pumped area
- 200: pump laser diode
- 300: pump radiation reflecting mirror
- 301: outer portion of mirror element
- 310: resonator folding mirror
- 311: central portion of mirror element
- 320: resonator end mirror
- 330: resonator outcoupling mirror
- 400: heat sink
- 500: laser radiation
- 510: pump radiation
- 600: mirror element

## Claims

1. An optically pumped solid state laser device comprising
- one or several solid state laser media (100) in a laser resonator, wherein the laser resonator is comprised by a VCSEL or semiconductor disc laser,
- said laser resonator being formed of one or several first resonator mirrors arranged at a first side of said solid state laser media (100) and one or several second resonator mirrors (310, 320, 330) arranged at a second side of said solid state laser media (100) opposing said first side, wherein the first resonator mirrors are formed of distributed Bragg reflectors on which said solid state laser media (100) are arranged,
- said first and second resonator mirrors (310, 320, 330) being arranged to guide laser radiation (500) of said laser resonator on at least two different straight paths through each of said laser media (100),
- one or several pump laser diodes (200) and pump radiation reflecting mirrors (300),
- said pump laser diodes (200) being arranged to optically pump said solid state laser media (100) by reflection of pump radiation (510) at said pump radiation reflecting mirrors (300),
- said pump radiation reflecting mirrors (300) being arranged on said second side and designed to directly reflect said pump radiation (510) to the solid state laser media (100),
- wherein said pump reflecting mirrors (300) and said second resonator mirrors (310, 320, 330) are integrally formed in a single mirror element (600), and.
- wherein the second resonator mirrors (310, 320, 330) comprise an outcoupling mirror (330) configured to allow passage of a portion of the laser radiation (500) through the outcoupling mirror (330) to an outside of said laser resonator.

2. The device according to claim 1,
wherein said solid state laser media (100) are mounted side by side on a cooling body (400).

3. The device according to claim 1,
wherein said solid state laser media (100) are formed of quantum-well structures on distributed Bragg reflectors.

4. The device according to claim 2,
wherein the device comprises at least two of said solid state laser media (100) each surrounded by several of said pump laser diodes (200) on said cooling body (400).

5. The device according to claim 4,
wherein the mirror element (600) comprises one pump radiation reflecting mirror (300) for each of said laser media (100), said pump radiation reflecting mirror (300) being arranged between said second resonator mirrors (310, 320, 330) and an outer one of said second resonator mirrors (310, 320, 330) being designed to form the outcoupling mirror.

6. The device according to claim 2,
wherein the device comprises one single of said solid state laser media (100) surrounded by several of said pump laser diodes (200) on said cooling body (400).

7. The device according to claim 6,
wherein the mirror element (600) comprises a central region (311) which forms said second resonator mirrors (310, 320, 330) and an outer region (301) which is designed to reflect said pump radiation (510) to the solid state laser medium (100) and forms said pump radiation reflecting mirror (300), one of said second resonator mirrors (310, 320, 330) being designed to form the outcoupling mirror.

8. The device according to claim 7,
wherein said outer region (301) of said mirror element (600) is designed to generate an intensity distribution of the pump radiation (510) in said solid state laser medium (100), which intensity distribution covers all of said different paths of the laser radiation (500) through the solid state laser medium (100).

9. The device according to claim 2,
wherein said pump laser diodes are arranged on said cooling body to surround each of said solid state laser media.

10. The device according to claim 2 or claim 6,
wherein said pump laser diodes are vertical cavity surface emitting lasers or electrically pumped vertical extended cavity surface emitting lasers.

## Patentansprüche

1. Optisch gepumptes Festkörperlasergerät, das Folgendes umfasst:
- mindestens ein Festkörperlasermedium (100) in einem Laserresonator, wobei der Laserresonator aus einem VCSEL oder einem Halbleiter-Scheibenlaser besteht,
- wobei der Laserresonator aus mindestens einem ersten Resonatorspiegel an einer ersten Seite des Festkörperlasermediums (100) sowie aus mindestens einem zweiten Resonatorspiegel (310, 320, 330) an einer zweiten, der ersten Seite gegenüberliegenden Seite des Festkörperlasermediums (100) besteht, wobei die ersten Resonatorspiegel aus verteilten Bragg-Reflektoren bestehen, auf denen sich die Festkörperlasermedien (100) befinden,
- wobei die ersten und zweiten Resonatorspiegel (310, 320, 330) die Laserstrahlung (500) des Laserresonators auf mindestens zwei verschiedenen geraden Wegen durch die einzelnen Lasermedien (100) führen,
- mindestens eine Pumplaserdiode (200) und mindestens ein reflektierende Pumpstrahlungsspiegel (300),
- wobei die Pumplaserdioden (200) das Festkörperlasermedium (100) optisch pumpen, indem die Pumpstrahlung (510) von den reflektierenden Pumpstrahlungsspiegeln (300) reflektiert wird,
- wobei die reflektierenden Pumpstrahlungsspiegel (300) auf der zweiten Seite angeordnet sind und die Pumpstrahlung (510) direkt auf das Festkörperlasermedium (100) reflektieren,
- wobei die reflektierenden Pumpstrahlungsspiegel (300) und die zweiten Resonatorspiegel (310, 320, 330) ein einziges Spiegelelement (600) bilden, und
- wobei die zweiten Resonatorspiegel (310, 320, 330) einen Auskopplungsspiegel (330) umfassen, der eines Teil der Laserstrahlung (500) durch den Auskopplungsspiegel (330) zur Außenseite des Laserresonators gelangen lässt.

2. Das Gerät gemäß Anspruch 1,
wobei die Festkörperlasermedien (100) nebeneinander auf einem Kühlkörper (400) angebracht sind.

3. Das Gerät gemäß Anspruch 1,
wobei es sich bei den Festkörperlasermedien (100) um Quantentopf-Strukturen auf den verteilten Bragg-Reflektoren handelt.

4. Das Gerät gemäß Anspruch 2,
wobei das Gerät mindestens zwei der Festkörperlasermedien (100) umfasst, die jeweils von mehreren der Pumplaserdioden (200) auf dem Kühlkörper (400) umgeben sind.

5. Das Gerät gemäß Anspruch 4,
wobei das Spiegelelement (600) für die einzelnen Lasermedien (100) jeweils einen reflektierenden Pumpstrahlungsspiegel (300) umfasst, wobei sich der reflektierende Pumpstrahlungsspiegel (300) zwischen den zweiten Resonatorspiegeln (310, 320, 330) angeordnet ist, und wobei der äußere der zweiten Resonatorspiegel (310, 320, 330) den Auskopplungsspiegel bildet.

6. Das Gerät gemäß Anspruch 2,
wobei das Gerät ein einzelnes Festkörperlasermedium (100) umfasst, das von mehreren der Pumplaserdioden (200) auf dem Kühlkörper (400) umgeben ist.

7. Das Gerät gemäß Anspruch 6,
wobei das Spiegelelement (600) einen zentralen, den zweiten Resonatorspiegel (310, 320, 330) bildenden Bereich (311) und einen äußeren Bereich (301) umfasst, der die Pumpstrahlung (510) auf das Festkörperlasermedium (100) reflektiert und den reflektierenden Pumpstrahlungsspiegel (300) bildet, wobei einer der zweiten Resonatorspiegel (310, 320, 330) den Auskopplungsspiegel bildet.

8. Das Gerät gemäß Anspruch 7,
wobei der äußere Bereich (301) des Spiegelelements (600) die Intensitätsverteilung der Pumpstrahlung (510) im Festkörperlasermedium (100) erzeugt, wobei die Intensitätsverteilung sämtliche Wege der Laserstrahlung (500) durch das Festkörperlasermedium (100) abdeckt.

9. Das Gerät gemäß Anspruch 2,
wobei die Pumplaserdioden auf dem Kühlkörper angeordnet sind und alle Festkörperlasermedien umgeben.

10. Das Gerät gemäß Anspruch 2 oder 6,
wobei es sich bei den Pumplaserdioden um Oberflächenemitter oder um elektrisch gepumpte Oberflächenemitter handelt.

## Revendications

1. Dispositif laser à solide à pompage optique comprenant
- au moins un milieu laser (100) à solide dans un résonateur laser, dans lequel le résonateur laser est composé d'un VCSEL ou d'un laser à disque semiconducteur,
- ledit résonateur laser étant formé d'au moins un premier miroir du résonateur agencé sur un premier côté dudit milieu laser (100) à solide et d'au moins un second miroir du résonateur (310, 320, 330) agencé sur un second côté dudit milieu laser (100) à solide, opposé audit premier côté, dans lequel les premiers miroirs du résonateur sont formés de réflecteurs de Bragg répartis sur lesquels lesdits milieux laser (100) à solide sont agencés,
- lesdits premier et second miroirs du résonateur (310, 320, 330) étant conçus pour guider le rayonnement laser (500) dudit résonateur laser sur au moins deux différentes trajectoires rectilignes à travers chacun desdits milieux laser (100),
- au moins une diode laser (200) de pompage et au moins un miroir (300) réfléchissant le rayonnement de pompage,
- lesdites diodes laser (200) de pompage étant conçues pour pomper de manière optique lesdits milieux laser (100) à solide par réflexion du rayonnement de pompage (510) sur lesdits miroirs (300) réfléchissant le rayonnement de pompage,
- lesdits miroirs (300) réfléchissant le rayonnement de pompage étant agencés sur ledit second côté et conçus pour réfléchir directement ledit rayonnement de pompage (510) vers les milieux laser (100) à solide,
- dans lequel lesdits miroirs (300) réfléchissant le rayonnement de pompage et lesdits seconds miroirs du résonateur (310, 320, 330) sont formés monobloc dans un seul élément miroir (600), et
- dans lequel les seconds miroirs du résonateur (310, 320, 330) comprennent un miroir de découplage (330) conçu pour permettre le passage d'une partie du rayonnement laser (500) à travers le miroir de découplage (330) vers un extérieur dudit résonateur laser.

2. Dispositif selon la revendication 1,
dans lequel lesdits milieux (100) à solide sont montés côte à côte sur un corps de refroidissement (400).

3. Dispositif selon la revendication 1,
dans lequel lesdits milieux laser (100) à solide sont formés de structures à puits quantiques sur des réflecteurs de Bragg distribués.

4. Dispositif selon la revendication 2,
dans lequel le dispositif comprend au moins deux desdits milieux laser (100) à solide entourés respectivement par plusieurs desdites diodes laser (200) de pompage sur ledit corps de refroidissement (400).

5. Dispositif selon la revendication 4,
dans lequel l'élément miroir (600) comprend un miroir (300) réfléchissant le rayonnement de pompage pour chacun desdits milieux laser (100), ledit miroir (300) réfléchissant le rayonnement de pompage étant agencé entre lesdits seconds miroirs du résonateur (310, 320, 330) et un second miroir du résonateur extérieur desdits seconds miroirs du résonateur (310, 320, 330) étant conçu pour former le miroir de découplage.

6. Dispositif selon la revendication 2,
dans lequel le dispositif comprend un seul desdits milieux laser (100) à solide entouré par plusieurs desdites diodes laser (200) de pompage sur ledit corps de refroidissement (400).

7. Dispositif selon la revendication 6,
dans lequel l'élément miroir (600) comprend une zone centrale (311), laquelle forme lesdits seconds miroirs du résonateur (310, 320, 330) et une zone extérieure (301), laquelle est conçue pour réfléchir ledit rayonnement de pompage (510) vers le milieu laser (100) à solide et laquelle forme ledit miroir (300) réfléchissant le rayonnement de pompage, l'un desdits seconds miroirs du résonateur (310, 320, 330) étant conçu pour former le miroir de découplage.

8. Dispositif selon la revendication 7,
dans lequel ladite zone extérieure (301) dudit élément miroir (600) est conçue pour générer une distribution d'intensité du rayonnement de pompage (510) dans ledit milieu laser (100) à solide, ladite distribution d'intensité couvrant toutes lesdites différentes trajectoires du laser rayonnement (500) à travers les milieux laser (100) à solide.

9. Dispositif selon la revendication 2,
dans lequel lesdites diodes laser de pompage sont agencées sur ledit corps de refroidissement pour entourer chacun desdits milieux laser à solide.

10. Dispositif selon la revendication 2 ou la revendication 6,
dans lequel lesdites diodes laser de pompage sont des lasers émetteurs de surface à cavité verticale ou des lasers émetteurs de surface à cavité étendue verticale pompés électriquement.
